# EUROPEAN PATENT APPLICATION

(11) **EP 2 958 253 A1**
(43) Date of publication of application: **23.12.2015**
(21) Application number: 14305962.4
(22) Date of filing: 20.06.2014
(51) Int. Cl.: H04B 10/50, H01S 5/00

(54) **Optical device comprising mode-locked laser components**

(71) Applicant: Alcatel Lucent, 92100 Boulogne-Billancourt (FR); Commissariat à l'Énergie Atomique et aux Énergies Alternatives, 75015 Paris (FR)
(72) Inventor: Kazmierski, Christophe, 91460 MARCOUSSIS (FR); Lelarge, François, 91460 MARCOUSSIS (FR)
(74) Representative: Novagraaf Technologies

(57) **Abstract**

An optical device (5) for generating a combined multi-wavelength optical signal (6) comprises:
• at least two mode-locked laser components (10), each mode-locked laser component (10) being able to generate an optical comb (13A, 13B) having a spectrum formed of a plurality of wavelengths with constant frequency spacing, the spectra of the generated optical combs (13A, 13B) being shifted, the frequency spacing values of said spectra being equal,
• means (12) for superimposing the generated optical combs (13A, 13B), said means (12) being connected to an output of each of the mode-locked laser components (10), said means (12) having an output (20) adapted to provide the combined multi-wavelength optical signal (6) formed of the superimposition of the generated optical signal combs (13A, 13B).

## Description

### Field of the Invention

The present invention generally relates to the field of optical communication networks, in particular to optical signal transmitters for optical communication networks. More particularly, but not exclusively, the present invention relates to optical devices for generating a combined multi-wavelength optical signal adapted for being used in a wavelength division multiplexing optical network.

### Background

In a typical optical communication network, optical signals are transmitted along optical links (typically, optical fibers) between nodes of the network. Typically, each optical signal results from the digital modulation of the amplitude and/or phase of the light emitted by a light source (such as a laser) included in a transmitter of a node, at a certain wavelength, and it propagates along an optical fiber.

For increasing the capacity of the optical fiber, it is also known to implement the Wavelength Division Multiplexing (WDM) technique, which consists in transmitting, along a same optical fiber, two or more optical signals onto light carriers having distinct wavelengths.

At the transmitter side, a coupler typically combines all the optical signals generated from the light sources into one optical fiber.

However, with the generation of each optical signal from the high frequency carrier modulation of the light emitted by one light source comes the problem of signal fading in the optical fiber.

Some solutions exist for reducing the cost and the level of signal fading in a device for generating optical signals in a multichannel communication network.

For example, an optical device has been proposed that generates, from one light source, a pair of two optical signals spaced by a given frequency, with one or two of them holding modulation data. The two separate signals propagate over fiber without fading. A high frequency carrier is produced in a receiver photo-detector, after the separation of the two signals and their mixing with modulation data. In the case of a WDM system, such an optical device is multiplied by the number of required pairs of light carriers.

However, such optical devices used in WDM systems include costly and bulky optical and electronic components. Moreover, due to the presence of a high-power local oscillator which is electrically supplied, such optical devices involve high power consumption.

Other devices, that each allows generating an optical comb, i.e. an optical signal having a spectrum formed of a plurality of wavelengths with constant frequency spacing, have also been proposed. Such an optical comb can then be used in a WDM network to provide each of the WDM light carriers. At least two wavelength combs with a same frequency spacing are interleaved to form wavelength pairs separated by a given frequency interval, in general different from the comb frequency spacing. For example, an optical device using an amplified loop modulation of a Mach-Zender modulator allowing the generation of such a WDM comb is known. However, such optical devices all include a high-power local oscillator which is electrically supplied. Thus, in spite of their main advantage of a very well controlled and constant frequency spacing due to the local oscillator frequency stability, these systems are complex and power consuming.

### Summary

So an object of this invention is to provide an optical device for generating a combined multi-wavelength optical signal having a reduced size, power consumption and cost.

According to a first aspect, the present invention provides an optical device for generating a combined multi-wavelength optical signal, the optical device comprising:
- at least two mode-locked laser components, each mode-locked laser component being able to generate an optical comb having a spectrum formed of a plurality of wavelengths with constant frequency spacing, the spectra of the generated optical combs being shifted, the frequency spacing values of said spectra being equal,
- means for superimposing the generated optical combs, said means being connected to an output of each of the mode-locked laser components, said means having an output adapted to provide the combined multi-wavelength optical signal formed of the superimposition of the generated optical combs.

The optical device may include additional characteristics considered separately or combined, and notably:
- each mode-locked laser component is a quantum dot mode-locked laser diode ;
- the optical device further comprises means for modulating at least one of the generated optical combs with base-band data ;
- the modulating means comprise at least one optical intensity modulator connected between an output of one of the mode-locked laser components and the superimposing means, said modulator being adapted for modulating the optical comb generated by said mode-locked laser component with said base-band data ;
- the modulating means are arranged within at least one of the mode-locked laser components and are adapted for directly modulating the laser of said mode-locked laser component with said base-band data ;
- the optical device further comprises means for amplifying the generated optical combs ;
- the amplifying means comprise an optical amplifier adapted for amplifying each generated optical comb, said optical amplifier being located within the superimposing means ;
- the optical amplifier is a semiconductor optical amplifier;
- the optical device further comprises at least two semi-transparent mirrors, the semi-transparent mirrors being arranged to face a laser end mirror of the mode-locked laser components so as to form a Fabry-Perot laser optical cavity, each mode-locked laser component being arranged in said cavity ;
- the semi-transparent mirrors are intra-chip mirrors formed of a waveguide gap, or photonic crystal or Bragg gratings ;
- the optical device is formed of a single integrated circuit, preferably a photonic integrated circuit.

According to a second aspect, the present invention provides an optical communication network comprising at a transmitter side an optical device for generating a combined multi-wavelength optical signal as set forth above, and at a receiver side means for filtering optically the combined multi-wavelength optical signal.

The optical communication network may include the additional feature wherein the optical communication network is a wavelength division multiplexing communication network and the filtering means comprise a wavelength division demultiplexer, said wavelength division demultiplexer being adapted for providing distinct optical signals to a plurality of receivers via a plurality of optical channels, each optical channel carrying one of said optical signals, the wavelength division demultiplexer being further adapted for selecting sets of associated wavelengths among the spectrum of the combined multi-wavelength optical signal so that each optical signal has a spectrum formed of one of said sets of associated wavelengths, the wavelengths within a given selected set of associated wavelengths being shifted.

Advantageously, this feature allows to transmit the combined multi-wavelength optical signal through a single optical fiber, thereby using effectively the broadband width of this optical fiber due to the absence of high frequency carrier modulation

According to a third aspect, the present invention provides a method for transmitting data to a plurality of receivers through an optical communication network, the optical communication network comprising at a transmitter side an optical device for generating a combined multi-wavelength optical signal and at a receiver side means for filtering optically the combined multi-wavelength optical signal, the optical device comprising:
- at least two mode-locked laser components, each mode-locked laser component being able to generate an optical comb having a spectrum formed of a plurality of wavelengths with constant frequency spacing,
- means for modulating at least one of the generated optical combs with base-band data,
- means for superimposing the generated optical combs, said means being connected to an output of each of the mode-locked laser components, said means having an output adapted to provide the combined multi-wavelength optical signal,
   said method comprising:
- using the mode-locked laser components of the optical device for generating at least two optical combs, each optical comb having a spectrum formed of a plurality of wavelengths with constant frequency spacing, the spectra of the generated optical combs being shifted, the frequency spacing values of said spectra being equal,
- using the modulating means of the optical device for modulating at least one of the generated optical combs with base-band data,
- using the superimposing means of the optical device for superimposing the generated optical combs so that to form the combined multi-wavelength optical signal,
- transmitting the combined multi-wavelength optical signal to the filtering means,
- using the filtering means for filtering optically the combined multi-wavelength optical signal,
- providing distinct optical signals to the plurality of receivers via a plurality of optical channels, each optical channel carrying one of said optical signals.

Advantageously, the method for transmitting data allows providing simultaneously distinct optical signals to the receivers, each optical signal containing dual or more wavelengths able to produce a microwave high frequency carrier signal at the corresponding receiver.

### Brief Description of the Figures

Some embodiments of apparatus and/or methods in accordance with embodiments of the present invention are now described, by way of example only, and with reference to the accompanying drawings, in which :
- The Figure 1 schematically and functionally illustrates an optical communication network comprising an optical device for generating a combined multi-wavelength optical signal according to the present invention,
- The Figure 2 schematically and functionally illustrates the optical device of Figure 1 according to a first embodiment of the present invention,
- The Figure 3 is a diagram illustrating the frequency spectrum of the combined multi-wavelength optical signal generated by the optical device of Figure 2,
- The Figure 4 schematically illustrates a flowchart of the method for transmitting data according to the invention, e.g. in the optical communication network of Figure 1, to a plurality of receivers,
- The Figure 5 schematically and functionally illustrates the optical device of Figure 1 according to a second embodiment of the present invention,
- The Figure 6 is a diagram illustrating the frequency spectrum of the combined multi-wavelength optical signal generated by the optical device of Figure 5.

### Description of Embodiments

In the following, the expression "optical comb" is intended to mean an optical signal having a spectrum formed of a plurality of wavelengths with constant frequency spacing.

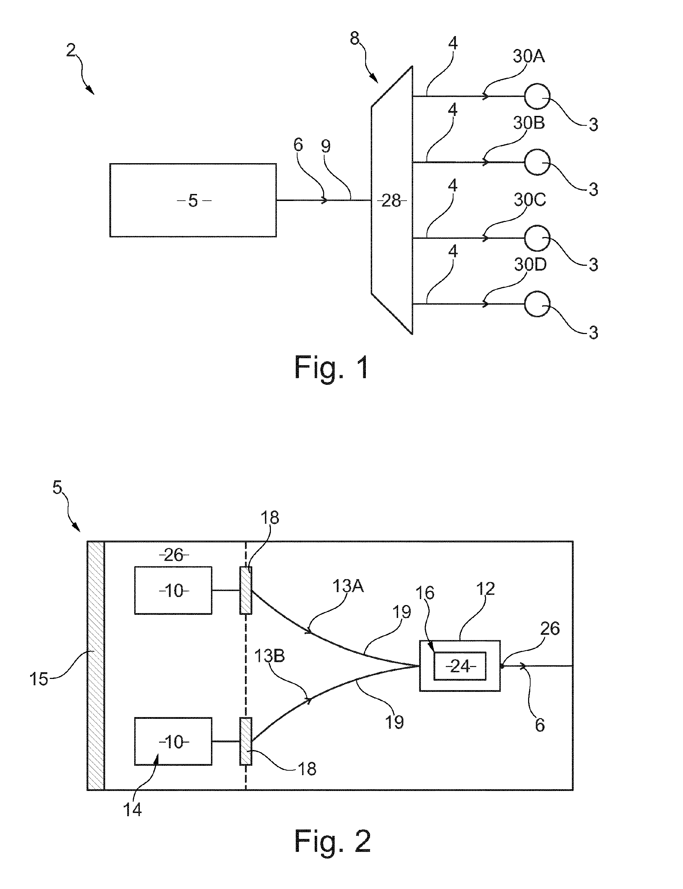

Figure 1 shows an optical communication network 2 connected to a set of several receivers 3 via several optical channels 4.

The optical communication network 2 comprises at a transmitter side an optical device 5 for generating a combined multi-wavelength optical signal 6 and at a receiver side means 8 for filtering optically the combined multi-wavelength optical signal 6. The filtering means 8 are connected to the optical device 5 thanks to an optical data link 9 comprising at least one optical fiber. In the exemplary embodiment of Figure 1, the optical communication network 2 is a wavelength division multiplexing communication network. But this is not limited to this kind of optical communication network. Besides, in the exemplary embodiment of Figure 1, the optical data link 9 comprises one single optical fiber.

Each receiver 3 is for example formed of a remote antenna unit adapted to convert an electrical signal into a radioelectric signal having a given frequency. In the exemplary embodiment of Figure 1, each remote antenna unit 3 is further adapted to emit wirelessly the radioelectric signal to a mobile terminal. In an alternative embodiment, not shown in the drawings, each receiver 3 comprises a wired optical network unit connected to a remote antenna unit. According to this embodiment, the set of receivers 3 are connected to filtering means and connecting fibers which form a passive optical network connected to the other end of the optical device 5.

The optical device 5 comprises at least two mode-locked laser components 10 and means 12 for superimposing optical combs 13A, 13B generated by the mode-locked laser components 10. In the exemplary embodiment of Figure 2, the optical device 5 comprises two mode-locked laser components 10.

Preferably, as shown in Figure 2, the optical device 5 further comprises means 14 for modulating at least one of the optical combs 13A, 13B with base-band data. Preferably, the optical device 5 further comprises means 16 for amplifying the generated optical combs 13A, 13B, and at least two semi-transparent mirrors 18. In the exemplary embodiment of Figure 2, the optical device 5 comprises two semi-transparent mirrors 18.

The optical device 5 is for example formed of a single integrated circuit. In the preferred embodiment of Figure 2, the optical device 5 is formed of a single photonic integrated circuit, more precisely a monolithic photonic integrated circuit. In an alternative embodiment not shown in the drawings, the optical device 5 is formed of a hybrid photonic integrated circuit.

The mode-locked laser components 10 are equipped with one laser end mirror 15 which is attached to one end of the mode-locked laser components 10.

Each mode-locked laser component 10 is able to generate an optical comb 13A, 13B having a spectrum formed of a plurality of wavelengths with constant frequency spacing. The mode-locked laser components 10 are selected so that the optical spectra of the generated optical combs 13A, 13B are shifted and the frequency spacing values of said spectra are equal. In the exemplary embodiment of Figure 2, the optical spectra of the two generated optical combs 13A, 13B are shifted by a given frequency interval. Preferably, each mode-locked laser component 10 is a quantum dot mode-locked laser diode. This feature allows increasing the number of wavelengths with constant frequency spacing in the spectrum of the generated optical combs 13A, 13B, as well as increasing the reproducibility of frequency spacing between the wavelengths of said generated optical combs 13A, 13B.

For example, each quantum dot mode-locked laser diode 10 includes an auto-pulsed laser adapted to auto-oscillate around a cavity frequency, the cavity frequency being equal to c/(2Lng) where c is the light speed, L is the cavity length and ng is an effective group refraction index of a laser waveguide. For example a mode-locked semi-conductor laser whose cavity length L is substantially equal to 400 µm will oscillate around a cavity frequency approximately equal to 100 GHz.

The superimposing means 12 are connected to an output of each of the mode-locked laser components 10, via waveguides 19. The superimposing means 12 have an output 20 adapted to provide the combined multi-wavelength optical signal 6. The combined multi-wavelength optical signal 6 is thus formed of the superimposition of the generated optical combs 13A, 13B. In the exemplary embodiment of Figure 2, the superimposing means 12 are formed of anoptical power combiner.

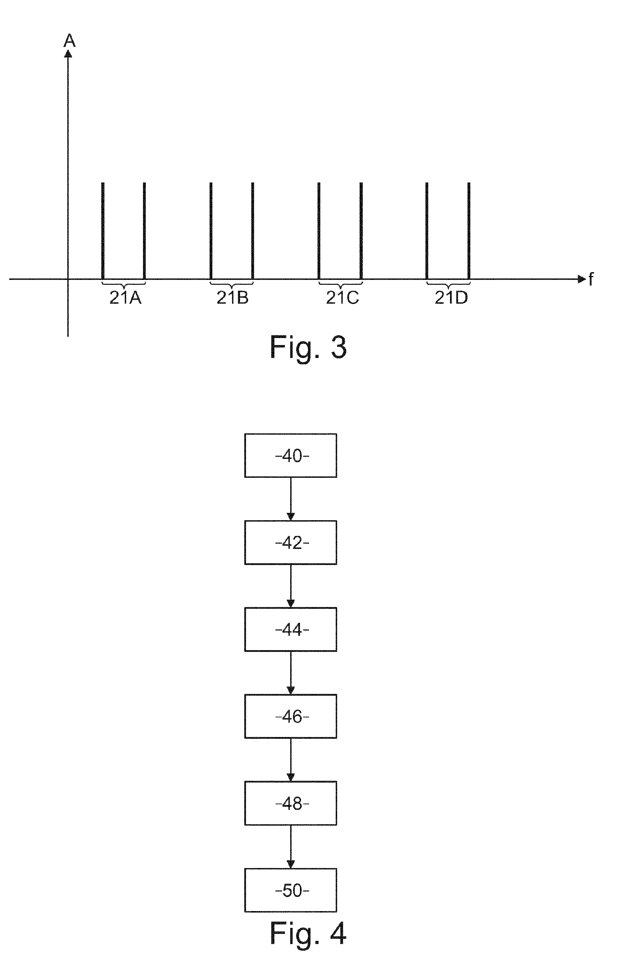

Figure 3 illustrates the optical spectrum of the combined multi-wavelength optical signal 6. More precisely, Figure 3 illustrates the amplitude versus frequency of the combined multi-wavelength optical signal 6. As shown in Figure 3, the optical spectrum defines sets 21 A, 21 B, 21C, 21 D of associated frequencies, and hence of associated wavelengths corresponding to said frequencies. According to the exemplary embodiment of Figure 2, each set 21 A, 21 B, 21C, 21 D comprises two associated frequencies. The wavelengths corresponding to the frequencies within a given set 21 A, 21 B, 21C, 21 D come from the optical combs 13A, 13B generated from distinct mode-locked laser components 10, and are shifted by the frequency interval.

In the exemplary embodiment of Figure 2, the modulating means 14 are arranged within one of the mode-locked laser components 10 and are adapted for directly modulating the laser of said mode-locked laser component 10 with base-band data, under the control of an external electrical modulator. In an alternative embodiment not shown in the drawings, the modulating means 14 are arranged within each mode-locked laser component 10.

In the exemplary embodiment of Figures 1 and 2, the base-band data is advantageously in the form of an Orthogonal Frequency-Division Multiplexing (OFDM) data carried by a number of electrical frequency carriers. This notably allows carrying on a specific electrical carrier a final addressing of a signal to a mobile terminal. In the alternative embodiment wherein each receiver 3 comprises a wired optical network unit connected to a remote antenna unit, the base-band data is in the form of time slots allowing slot recognition at the corresponding optical network unit.

In the exemplary embodiment of Figure 2, the amplifying means 16 comprise an optical amplifier 24. In this exemplary embodiment, the optical amplifier 24 is located within the superimposing means, namely within the optical combiner 12. Alternatively, the amplifying means 16 are separated from the superimposing means 12 and are for example connected to the output 20 of the optical combiner 12 or are arranged externally, after the output of the optical device 5.

The optical amplifier 24 is adapted for amplifying each generated optical comb 13A, 13B. Preferably, the optical amplifier 24 is a semiconductor optical amplifier. This allows integrating the amplifier 24 into the photonic circuit and using it to increase optical output power and to compensate for optical propagation losses of the integrated photonic circuit.

In the exemplary embodiment of Figure 2, the two semi-transparent mirrors 18 are arranged to face the laser end mirror 15 so as to form a Fabry-Perot laser optical cavity 26. According to this embodiment, the mode-locked laser components 10 and the modulating means 14 are arranged in the cavity 26, and the superimposing means 12 and the amplifying means 16 are arranged out of the cavity 26. This allows to ease the further combination and amplification of the generated optical combs 13A, 13B.

Preferably, each semi-transparent mirror 18 is an intra-chip mirror formed for example of a waveguide gap, or photonic crystal or Bragg gratings.

In the exemplary embodiment of Figure 1, the filtering means 8 comprise a wavelength division demultiplexer 28. In the alternative embodiment wherein each receiver 3 comprises a wired optical network unit connected to a remote antenna unit, the wavelength division demultiplexer 28 advantageously provides adequate addressing to the receivers 3. In an alternative embodiment not shown in the drawings, the filtering means 8 comprise a power splitter associated to several optical fibers, each optical fiber forming one of the optical channels 4. In this case, the optical filtering means 8 are combined with the receivers 3.

Classically, the wavelength division demultiplexer 28 is adapted for providing distinct optical signals 30A, 30B, 30C, 30D to the receivers 3 via the optical channels 4, by filtering optically the combined multi-wavelength optical signal 6. In the exemplary embodiment of Figures 1 and 2, the wavelength division demultiplexer 28 is further adapted for selecting each set 21 A, 21 B, 21C, 21 D of associated wavelengths among the spectrum of the combined multi-wavelength optical signal 6, so that each optical signal 30A, 30B, 30C, 30D has a spectrum formed of one of the sets 21 A, 21 B, 21C, 21 D of associated wavelengths.

The method for transmitting data to the receivers 3 through the optical communication network 2 according to the invention will now be described in detail with reference to Figure 4.

The method comprises a first step 40 during which the mode-locked laser components 10 generate at least two optical combs. In the exemplary embodiment of Figure 2, the two mode-locked laser components 10 generate the two optical combs 13A, 13B.

In a following step 42, the modulating means 14 modulate at least one of the generated optical combs 13A, 13B with base-band data. In the exemplary embodiment of Figure 2, the modulating means 14 directly modulates one comb 13B among the generated optical combs 13A, 13B with Orthogonal Frequency-Division Multiplexing data. At the end of the step 42, the waveguides 19 transmit the generated optical combs 13A, 13B to the superimposing means 12. Alternatively, the modulation step 42 is performed in parallel of the generation step 40.

In a following step 44, the superimposing means 12 superimpose the generated optical combs 13A, 13B so that to form the combined multi-wavelength optical signal 6. At the end of the step 44, the superimposing means 12 provide the combined multi-wavelength optical signal 6 on their output 20.

In a following step 46, the optical data link 9 transmits the combined multi-wavelength optical signal 6 to the filtering means 8.

In a following step 48, the filtering means 8 filter optically the combined multi-wavelength optical signal 6. More precisely, in the exemplary embodiment of Figures 1 and 2, the wavelength division demultiplexer 28 selects the sets 21 A, 21 B, 21C, 21 D of associated wavelengths among the optical spectrum of the combined multi-wavelength optical signal 6.

In a following step 50, the filtering means 8 provide distinct optical signals 30A, 30B, 30C, 30D to the receivers 3 via the optical channels 4. Each optical signal 30A, 30B, 30C, 30D has a spectrum formed of one of the sets 21 A, 21 B, 21C, 21 D of associated wavelengths. At the end of the step 50, each receiver 3 produces a microwave high frequency electrical carrier, the frequency of which corresponds to the frequency interval between the received wavelengths of a given set 21 A, 21 B, 21C, 21 D. Each receiver 3 then up-converts the base-band data contained in the corresponding optical signal 30A, 30B, 30C, 30D.

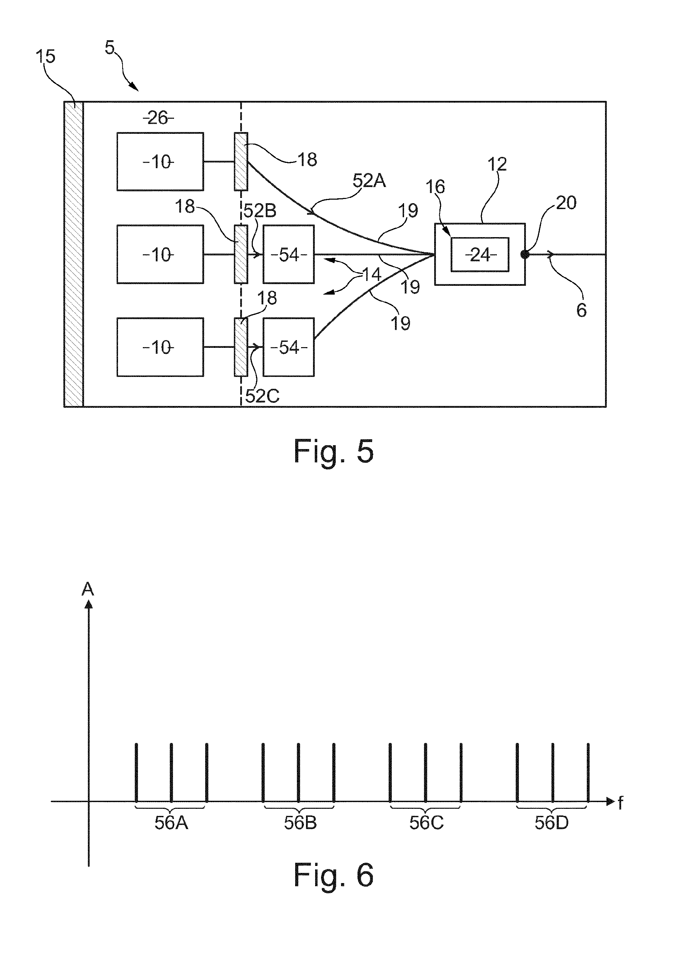

Figure 5 illustrates a second embodiment of the optical device according to the invention wherein elements similar to the first embodiment described above are identified by identical reference numbers and thus are not described again.

The optical device 5 comprises three mode-locked laser components 10 and three semi-transparent mirrors 18. Each mode-locked laser component 10 is able to generate an optical comb 52A, 52B, 52C having a spectrum formed of a plurality of wavelengths with constant frequency spacing. The mode-locked laser components 10 are selected so that the optical spectra of the generated optical combs 52A, 52B, 52C are shifted and the frequency spacing values of said spectra are equal. In the exemplary embodiment of Figure 5, the optical spectra of the three generated optical combs 52A, 52B, 52C are shifted by two equal frequency intervals. In an alternative embodiment, not shown in the drawings, the optical spectra of the three generated optical combs 52A, 52B, 52C are shifted by two different frequency intervals.

According to this second embodiment of the invention, the modulating means 14 comprise at least one optical intensity modulator 54 connected between an output of one of the mode-locked laser components 10 and the superimposing means 12. The or each modulator 54 is adapted for modulating the optical comb 52A, 52B, 52C generated by the corresponding mode-locked laser component 10 with base-band data, under the control of an external electrical modulator. In the exemplary embodiment of Figure 5, the modulating means 14 comprise two modulators 54, each modulator 54 being for example formed of an electro-absorption modulator.

Compared to the first embodiment, the optical device 5 according to this second embodiment has an increased modulation bandwidth, due to the presence of the modulators 54.

Moreover, the optical device 5 according to this second embodiment is particularly suitable for enhanced applications such as for example compatibility with a wired passive optical network comprising several optical network units connected to remote antenna units, or in case of a multi microwave carrier wireless communication.

Figure 6 illustrates the frequency spectrum of the combined multi-wavelength optical signal 6. More precisely, Figure 6 illustrates the amplitude versus frequency of the combined multi-wavelength optical signal 6. As shown in Figure 6, the spectrum defines sets 56A, 56B, 56C, 56D of associated frequencies, and hence of associated wavelengths corresponding to said frequencies. According to the exemplary embodiment of Figure 5, each set 56A, 56B, 56C, 56D comprises three associated frequencies. The wavelength corresponding to the frequencies within a given set 56A, 56B, 56C, 56D come from the optical combs 52A, 52B, 52C generated from distinct mode-locked laser components 10, and are shifted by the two frequency intervals. For example, within a given set of associated wavelengths, two of the three wavelengths hold the modulated optical signals coming from the generated optical combs 52B, 52C, while one of the wavelengths comes from the non-modulated optical comb 52A.

The operation of this second embodiment of the optical device 5 is similar to that of the first embodiment and is therefore not described in greater detail. At the end of the step 50, each optical signal 30A, 30B, 30C, 30D has a spectrum formed of one of the sets 56A, 56B, 56C, 56D of associated wavelengths, and each receiver 3 produces a microwave high frequency carrier and up-converts the base-band data contained in the corresponding optical signal 30A, 30B, 30C, 30D.

The optical communication network comprising the optical device according to the invention offers several advantages:
- the component count in the optical communication network is put down by several tenths times compared to the solutions of the prior art, bringing the same cost reduction ratio,
- the need of a high power electrically supplied local oscillator in the optical device is suppressed, which allows reducing the power consumed by the optical device. For example, all the power savings made in the optical device according to the invention, due notably to low modulation power as well as the absence of a high power local oscillator, correspond to a reduction by a factor of about ten compared to the power consumption of the Mach-Zender modulator of the prior art. This allows to further reduce the costs.
- the optical device being formed of an integrated circuit who has a millimeter size, the size of the optical device is reduced. For example, the size of the optical device according to the invention has a centimeter size, which corresponds to a reduction by a factor of about ten compared to the size of the Mach-Zender modulator of the prior art. This allows to further reduce the costs.
- when used in a wavelength division multiplexing communication network connected to a set of remote antenna units, the optical device brings a major simplification of central office radio transmitters in terms of complexity, size and power consumption.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope.

Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Optical device (5) for generating a combined multi-wavelength optical signal (6), the optical device (5) comprising:
• at least two mode-locked laser components (10), each mode-locked laser component (10) being able to generate an optical comb (13A, 13B ; 52A, 52B, 52C) having a spectrum formed of a plurality of wavelengths with constant frequency spacing, the spectra of the generated optical combs (13A, 13B ; 52A, 52B, 52C) being shifted, the frequency spacing values of said spectra being equal,
• means (12) for superimposing the generated optical combs (13A, 13B ; 52A, 52B, 52C), said means (12) being connected to an output of each of the mode-locked laser components (10), said means (12) having an output (20) adapted to provide the combined multi-wavelength optical signal (6) formed of the superimposition of the generated optical combs (13A, 13B ; 52A, 52B, 52C).

2. Optical device (5) according to claim 1, wherein each mode-locked laser component (10) is a quantum dot mode-locked laser diode.

3. Optical device (5) according to claim 1 or 2, wherein the optical device (5) further comprises means (14) for modulating at least one of the generated optical combs (13A, 13B ; 52A, 52B, 52C) with base-band data.

4. Optical device (5) according to claim 3, wherein the modulating means (14) comprise at least one optical intensity modulator (54) connected between an output of one of the mode-locked laser components (10) and the superimposing means (12), said modulator (54) being adapted for modulating the optical comb (52B, 52C) generated by said mode-locked laser component (10) with said base-band data.

5. Optical device (5) according to claim 3, wherein the modulating means (14) are arranged within at least one of the mode-locked laser components (10) and are adapted for directly modulating the laser of said mode-locked laser component (10) with said base-band data.

6. Optical device (5) according to any one of the preceding claims, wherein the optical device (5) further comprises means (16) for amplifying the generated optical combs (13A, 13B ; 52A, 52B, 52C).

7. Optical device (5) according to claim 6, wherein the amplifying means (16) comprise an optical amplifier (24) adapted for amplifying each generated optical comb (13A, 13B ; 52A, 52B, 52C), said optical amplifier (24) being located within the superimposing means (12).

8. Optical device (5) according to claim 7, wherein the optical amplifier (24) is a semiconductor optical amplifier.

9. Optical device (5) according to any one of the preceding claims, wherein the optical device (5) further comprises at least two semi-transparent mirrors (18), the semi-transparent mirrors (18) being arranged to face a laser end mirror (15) of the mode-locked laser components (10) so as to form an optical Fabry-Perot laser cavity (26), each mode-locked laser component (10) being arranged in said cavity (26).

10. Optical device (5) according to claim 9, wherein the semi-transparent mirrors (18) are intra-chip mirrors formed of a waveguide gap, or photonic crystal or Bragg gratings.

11. Optical device (5) according to any one of the preceding claims, wherein the optical device (5) is formed of a single integrated circuit, preferably a photonic integrated circuit.

12. Optical communication network (2) comprising at a transmitter side an optical device (5) for generating a combined multi-wavelength optical signal (6) and at a receiver side means (8) for filtering optically the combined multi-wavelength optical signal (6), the optical device (5) being an optical device according to any of the preceding claims.

13. Optical communication network (2) according to claim 12, wherein the optical communication network (2) is a wavelength division multiplexing communication network and the filtering means (8) comprise a wavelength division demultiplexer (28), said wavelength division demultiplexer (28) being adapted for providing distinct optical signals (30A, 30B, 30C, 30D) to a plurality of receivers (3) via a plurality of optical channels (4), each optical channel (4) carrying one of said optical signals (30A, 30B, 30C, 30D), the wavelength division demultiplexer (28) being further adapted for selecting sets (21 A, 21 B, 21C, 21 D ; 56A, 56B, 56C, 56D) of associated wavelengths among the optical spectrum of the combined multi-wavelength optical signal (6) so that each optical signal (30A, 30B, 30C, 30D) has a spectrum formed of one of said sets (21 A, 21 B, 21C, 21 D ; 56A, 56B, 56C, 56D) of associated wavelengths, the wavelengths within a given selected set of associated wavelengths being shifted.

14. Method for transmitting data to a plurality of receivers (3) through an optical communication network (2), the optical communication network (2) comprising at a transmitter side an optical device (5) for generating a combined multi-wavelength optical signal (6) and at a receiver side means (8) for filtering optically the combined multi-wavelength optical signal (6), the optical device (5) comprising:
• at least two mode-locked laser components (10), each mode-locked laser component (10) being able to generate an optical comb (13A, 13B ; 52A, 52B, 52C) having a spectrum formed of a plurality of wavelengths with constant frequency spacing,
• means (14) for modulating at least one of the generated optical combs (13A, 13B ; 52A, 52B, 52C) with base-band data,
• means (12) for superimposing the generated optical combs (13A, 13B ; 52A, 52B, 52C), said means (12) being connected to an output of each of the mode-locked laser components (10), said means (12) having an output (20) adapted to provide the combined multi-wavelength optical signal (6),
said method comprising:
• using the mode-locked laser components (10) of the optical device (5) for generating (40) at least two optical combs (13A, 13B ; 52A, 52B, 52C), each optical comb (13A, 13B ; 52A, 52B, 52C) having a spectrum formed of a plurality of wavelengths with constant frequency spacing, the spectra of the generated optical combs (13A, 13B ; 52A, 52B, 52C) being shifted, the frequency spacing values of said spectra being equal,
• using the modulating means (14) of the optical device (5) for modulating (42) at least one of the generated optical combs (13A, 13B ; 52A, 52B, 52C) with base-band data,
• using the superimposing means (12) of the optical device (5) for superimposing (44) the generated optical combs (13A, 13B ; 52A, 52B, 52C) so that to form the combined multi-wavelength optical signal (6),
• transmitting (46) the combined multi-wavelength optical signal (6) to the filtering means (8),
• using the filtering means (8) for filtering (48) optically the combined multi-wavelength optical signal (6),
• providing (50) distinct optical signals (30A, 30B, 30C, 30D) to the plurality of receivers (3) via a plurality of optical channels (4), each optical channel (4) carrying one of said optical signals (30A, 30B, 30C, 30D).
